# EUROPEAN PATENT APPLICATION

(11) **EP 3 579 280 A1**
(43) Date of publication of application: **11.12.2019**
(21) Application number: 19170432.9
(22) Date of filing: 19.04.2019
(51) Int. Cl.: H01L 29/778, H01L 29/08, H01L 29/417, H01L 29/06, H01L 29/20

(54) **CONTACT SHAPE FOR IMPROVED PERFORMANCE IN GAN RF TRANSISTORS**

(30) Priority: 06.06.2018 US 201816001791
(71) Applicant: INTEL Corporation, Santa Clara, CA 95054 (US)
(72) Inventor: RADOSAVLJEVIC, Marko, Portland, OR 97229 (US); THEN, Han Wui, Portland, OR 97229 (US); DASGUPTA, Sansaptak, Hillsboro, OR 97124 (US); FISCHER, Paul, Portland, OR 97229 (US); HAFEZ, Walid, Portland, OR 97229 (US)
(74) Representative: HGF Limited

(57) **Abstract**

Embodiments described herein comprise a transistor device that comprises a GaN channel. In an embodiment, the transistor device further comprises a source region and a drain region. The source region may be separated from the drain region by the GaN channel. In an embodiment, the source region and the drain region comprise surfaces with a root mean squared (RMS) surface roughness greater than 3 nm. In an embodiment, the transistor device further comprises a gate electrode over the GaN channel, a source contact in contact with source region, and a drain contact in contact with the drain region.

## Description

### TECHNICAL FIELD

Embodiments of the disclosure are in the field of semiconductor structures and processing and, in particular, to the contact surfaces of gallium nitride (GaN) transistors.

### BACKGROUND

The need for transistor technologies with high breakdown voltages is increasing. High-breakdown voltage transistors are needed for power delivery applications, and more particularly for communication technologies. With respect to communication technologies, transistors with a high breakdown voltage are needed in order to enable the transition to 5G communication standards.

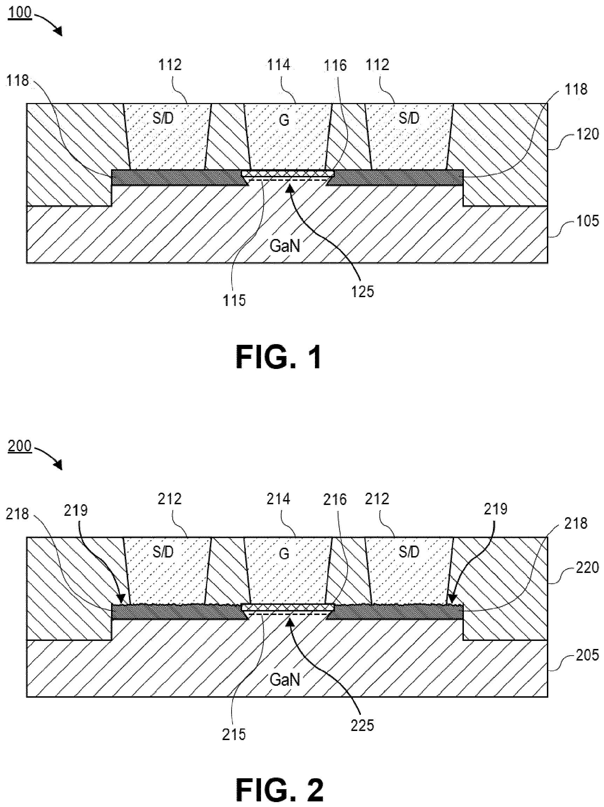

GaN transistors enable high breakdown voltages due to the large band-gap. Figure 1 is a cross-sectional illustration of a GaN transistor 100. The GaN transistor 100 may be formed on a GaN substrate 105. A GaN channel 125 may separate N⁺ doped source/drain (S/D) regions 118. An electron gas 115 and a polarization layer 116 may separate the channel 125 from the gate stack 114. A shallow trench isolation (STI) 120 may electrically isolate the gate stack 114 from the S/D contacts 112.

The large band-gap of GaN also presents challenges that need to be overcome. One challenge is that GaN transistors have a high contact resistance. A high contact resistance between the S/D contacts 112 and the S/D regions 118 reduces the efficiency of the transistor. Contact resistance is typically minimized by choosing a contact material that has a work function that matches the band-edge of the source/drain region of the transistor. However, the large band-gap of GaN makes it difficult to engineer contact materials that have a low contact resistance.

### BRIEF DESCRIPTION OF THE DRAWINGS

Figure 1 is a cross-sectional illustration of a gallium nitride (GaN) transistor.
Figure 2 is a cross-sectional illustration of a GaN transistor with source and drain regions that have roughened surfaces, in accordance with an embodiment.
Figure 3A is a cross-sectional illustration of a GaN transistor with source and drain regions that have a major surface and a recessed surface, in accordance with an embodiment.
Figure 3B is a cross-sectional illustration along a source/drain region that illustrates the recessed surface of the source/drain region, in accordance with an embodiment.
Figure 3C is a cross-sectional illustration along a source/drain region that illustrates a plurality of recessed surfaces of the source/drain region, in accordance with an embodiment.
Figure 4A is a cross-sectional illustration of a GaN transistor with source and drain regions that have a roughened major surface and roughened recessed surface, in accordance with an embodiment.
Figure 4B is a cross-sectional illustration of a portion of the GaN transistor that illustrates the roughened major surface and the roughened recessed surface of a source/drain region, in accordance with an embodiment.
Figure 5A is a cross-sectional illustration of a GaN transistor with non-planar source and drain regions formed over and around semiconductor protrusions, in accordance with an embodiment.
Figure 5B is a cross-sectional illustration along a non-planar source/drain region that is formed over and around a semiconductor fin, in accordance with an embodiment.
Figure 5C is a cross-sectional illustration along a non-planar source/drain region that is formed over and around a plurality of semiconductor protrusions, in accordance with an embodiment.
Figure 6 illustrates a computing device in accordance with one implementation of an embodiment of the disclosure.
Figure 7 is an interposer implementing one or more embodiments of the disclosure.

### DESCRIPTION OF THE EMBODIMENTS

Gallium nitride (GaN) transistors with improved contact resistance and methods of forming such devices are described in accordance with embodiments. In the following description, numerous specific details are set forth, such as specific integration and material regimes, in order to provide a thorough understanding of embodiments of the present disclosure. It will be apparent to one skilled in the art that embodiments of the present disclosure may be practiced without these specific details. In other instances, well-known features, such as integrated circuit design layouts, are not described in detail in order to not unnecessarily obscure embodiments of the present disclosure. Furthermore, it is to be appreciated that the various embodiments shown in the Figures are illustrative representations and are not necessarily drawn to scale.

Certain terminology may also be used in the following description for the purpose of reference only, and thus are not intended to be limiting. For example, terms such as "upper", "lower", "above", "below," "bottom," and "top" refer to directions in the drawings to which reference is made. Terms such as "front", "back", "rear", and "side" describe the orientation and/or location of portions of the component within a consistent but arbitrary frame of reference which is made clear by reference to the text and the associated drawings describing the component under discussion. Such terminology may include the words specifically mentioned above, derivatives thereof, and words of similar import.

As noted above, the efficiency of GaN transistors is reduced due to poor contact resistance. Accordingly, embodiments described herein include GaN transistors with contact schemes that decrease the contact resistance. Particularly, embodiments include GaN transistors with contact schemes that increase the surface area for a given footprint compared to contact schemes such as those described above with respect to Figure 1. The contact resistance is a function of the intrinsic resistance of the interface (due to the difference between the work function of the contact and the band edge of the semiconductor) and the surface area of the interface. As such, increasing the total surface area of the interface for a given footprint will provide an overall reduction in the contact resistance.

In one embodiment, the increased surface area is provided by roughening the surface of the epitaxially grown source/drain (S/D) regions. In an additional embodiment, the increased surface area is provided by forming non-planar S/D regions. As used herein, a "non-planar" S/D region refers to an S/D region that comprises surfaces oriented (i.e., facing) more than one direction. In one embodiment, the non-planar S/D region may include one or more depressions. For example, the S/D regions may have a major surface and a recessed surface. In another embodiment, the S/D region may be formed over and around semiconductor protrusions. In embodiments, the non-planar S/D regions may also include roughened surfaces in order to further increase the surface area of the interface between the S/D regions and the S/D contacts.

Referring now to Figure 2, a cross-sectional illustration of a GaN transistor 200 is shown, in accordance with an embodiment. In an embodiment, the GaN transistor 200 may comprise a GaN channel 225. The GaN channel 225 may be part of a GaN substrate layer 205. In an embodiment, GaN substrate layer 205 may be formed over any suitable underlying substrate or structure (not shown). In an embodiment, an underlying substrate represents a general workpiece object used to manufacture integrated circuits. The underlying substrate often includes a wafer or other piece of silicon or another semiconductor material. Suitable semiconductor substrates include, but are not limited to, single crystal silicon, polycrystalline silicon and silicon on insulator (SOI), as well as similar substrates formed of other semiconductor materials, such as substrates including germanium, carbon, or group III-V materials. The underlying substrate may also include semiconductor materials, metals, dielectrics, dopants, and other materials commonly found in semiconductor substrates.

In an embodiment, GaN transistor 200 may also comprise a two-dimensional electron gas (2DEG), which may be located at the abrupt hetero-interface formed by epitaxial deposition of a charge-inducing film 216 with larger spontaneous and piezoelectric polarization (referred to herein as a polarization layer 216). The polarization layer 216 may include aluminum nitride (AlN), aluminum gallium nitride (AlGaN), indium aluminum nitride (InAIN), indium aluminum gallium nitride (InAlGaN), or any other suitable material, depending on the end use or target application.

In an embodiment, a gate stack 214 may be positioned over the channel 225. In some embodiments, the formation of gate stack 214 may include dummy gate oxide deposition, dummy gate electrode (e.g., poly-Si) deposition, and patterning hardmask deposition. Additional processing may include patterning the dummy gates and depositing/etching spacer material. Following such processes, the method may continue with insulator 220 deposition, planarization, and then dummy gate electrode and gate oxide removal to expose the polarization layer 216 over the channel layer 225 of the transistor, such as is done for a replacement metal gate (RMG) process. Following opening the channel region, the dummy gate oxide and electrode may be replaced with, for example, a gate dielectric and a replacement metal gate, respectively. Other embodiments may include a standard gate stack formed by any suitable process, such as a subtractive process where the gate dielectric/gate metal is deposited and then followed by one or more etching processes. Any number of standard back-end processes may also be performed to help complete the formation of one or more transistors. In the example structure shown in Figure 2, the gate stack 214 may include a gate electrode and a gate dielectric formed directly under the gate electrode. The gate dielectric and gate electrode may be formed using any suitable technique and from any suitable materials. For example, the gate stack may have been formed during a replacement metal gate process, as previously described, and such a process may include any suitable deposition technique (e.g., CVD, PVD, etc.). The gate dielectric may be, for example, any suitable oxide such as silicon dioxide or high-k gate dielectric materials. Examples of high-k gate dielectric materials include, for instance, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate. In some embodiments, an annealing process may be carried out on the gate dielectric layer to improve its quality when a high-k material is used. In general, the thickness of the gate dielectric should be sufficient to electrically isolate the gate electrode from the source and drain contacts. Further, the gate electrode may comprise a wide range of materials, such as polysilicon, silicon nitride, silicon carbide, or various suitable metals or metal alloys, such as aluminum (Al), tungsten (W), titanium (Ti), tantalum (Ta), copper (Cu), titanium nitride (TiN), or tantalum nitride (TaN), for example. Various back end processes can also be performed, such as forming contacts 212 on the S/D regions 218 using, for example, a silicidation process (generally, deposition of contact metal and subsequent annealing).

In order to increase the surface area of the interface between the S/D contacts 212 and the S/D regions 218, the S/D regions 218 may be formed with a roughened surface 219. A roughened surface 219 produces non-horizontal surfaces within the footprint of the S/D contact 212. As used herein, a "non-horizontal surface" is a surface that is not parallel to a major or primary surface of the underlying substrate 205. The inclusion of non-horizontal surfaces provides additional surface area for the interface without needing to expand the footprint. As used herein, a roughened surface may refer to a surface that is non-polished (e.g., with a chemical mechanical planarization (CMP) process). In an embodiment, a roughened surface may refer to a surface roughness that is greater than a surface roughness of S/D regions in existing GaN transistors with planar S/D regions. For example, S/D regions of many currently available GaN transistors may have a root mean squared (RMS) value of 2 nm or less. The RMS value of a surface denotes the standard height deviation of a surface scan over a surface of the S/D region. In embodiments described herein, a roughened surface may refer to a S/D region 218 that includes a surface 219 that has a RMS value of 3 nm or greater.

In an embodiment, the surface 219 of the S/D regions 218 may be roughened during an epitaxial growth process used to form the S/D regions 218. In a particular embodiment, the S/D regions 218 may be epitaxially grown with a semiconducting material that has a different lattice constant than the semiconductor substrate 205. A difference in the lattice constants results in strain being induced in the S/D region 218. As the thickness of the strained S/D region 218 increases, the strain begins to relax by deforming the surface 219. The deformed surface results in a roughened surface described in embodiments disclosed herein. In an embodiment, an average thickness of the S/D region 218 with a roughened surface 219 may be 50 nm and 200 nm.

It is to be appreciated that if the difference between the lattice constants of the semiconductor substrate 205 and the S/D region 218 is too large or too small the desired roughening may not be obtainable. Accordingly, in some embodiments the difference in the lattice constant of the semiconductor substrate 205 and the S/D region 218 may be between 0.5% and 10%. In an embodiment, the difference in the lattice constant of the semiconductor substrate 205 and the S/D region 218 may be greater than 3%. In embodiments where the semiconductor substrate 205 is GaN, the S/D regions 218 may be formed with indium gallium nitride (InGaN). The difference in the lattice constants may be controlled by changing the atomic percentage of In in the InGaN. For example, the atomic weight percent of In in InGaN may be 1% or greater. In an embodiment, the atomic weight percent of In in InGaN may be 15% or greater. In an embodiment, the atomic weight percent of In in InGaN may be between 15% and 20%.

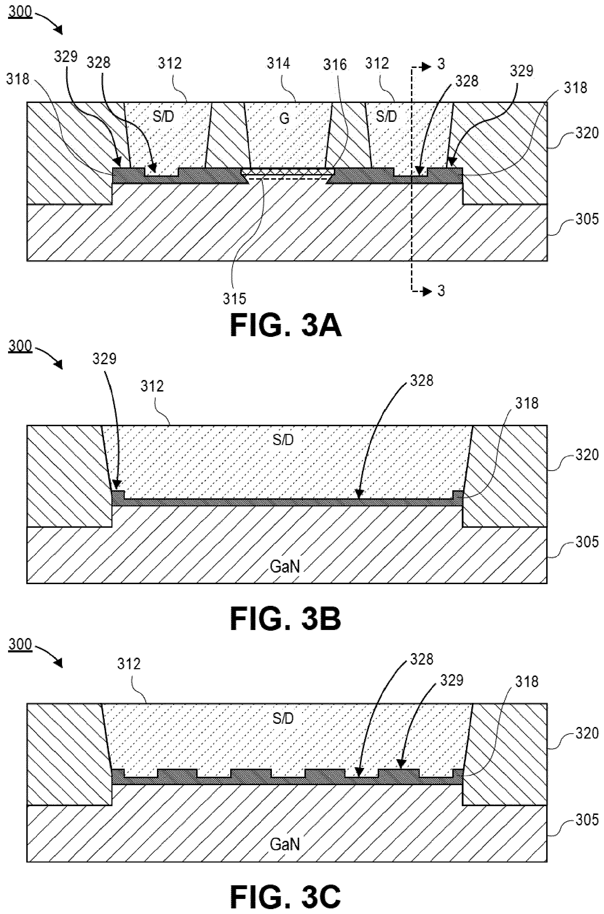

Referring now to Figure 3A, a cross-sectional illustration of a GaN transistor 300 that comprises non-planar S/D regions 318 is shown, in accordance with an embodiment. In an embodiment, GaN transistor 300 comprises S/D regions 318 that comprise a major surface 329 and a recessed surface 328. In an embodiment, the recessed surface 328 may be recessed relative to the major surface 329. In an embodiment, the recessed surface 328 may be recessed with an etching process. Recessing a portion of the surface of the S/D region 318 produces non-horizontal surfaces that may be contacted by the S/D contacts 312, therefore increasing the total surface area of the interface without increasing the footprint of the S/D region 318.

Referring now to Figure 3B, a cross-sectional illustration of a S/D region 318 of a GaN transistor 300 along line 3-3' is shown, in accordance with an embodiment. As shown, the recessed surface 328 may be a single depression along the S/D region 318 that is surrounded by the major surface 329. Referring now to Figure 3C, a cross-sectional illustration of a S/D region 318 of a GaN transistor 300 along line 3-3' is shown, in accordance with another embodiment. As shown, a plurality of recessed surfaces 328 may be formed into the S/D region 318. Increasing the number of recesses further increases the surface area of the interface between the S/D region 318 and the S/D contact 312 since there are more non-horizontal surfaces. It is to be appreciated that while the non-horizontal surfaces in Figures 3A-3C are shown as being substantially vertical, embodiments are not limited to substantially vertical surfaces. Furthermore, while the recessed surfaces 328 are illustrated as being substantially horizontal, embodiments are not limited to substantially horizontal recessed surfaces 328.

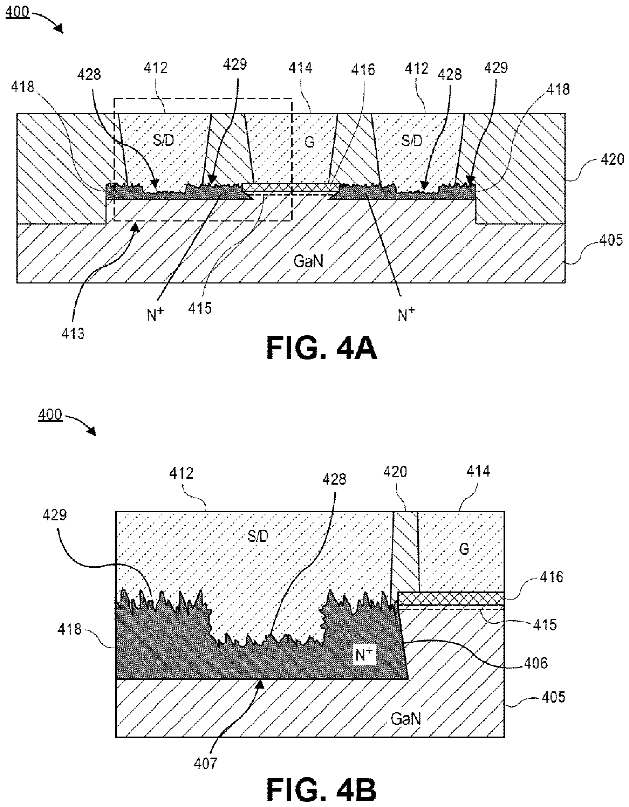

Referring now to Figure 4A, a cross-sectional illustration of a GaN transistor 400 with non-planar S/D regions 418 is shown, in accordance with an embodiment. In an embodiment, the GaN transistor 400 may be substantially similar to the GaN transistor 300 described above, with the exception that the surfaces of the S/D regions 418 are roughened. The S/D regions 418 may be roughened with processes similar to those described above with respect to Figure 2. For example, the S/D regions 418 may comprise a semiconductor material that has a different lattice constant than the semiconductor substrate 405.

In an embodiment, the difference in the thickness of the S/D region 418 between the major surface 429 and recessed surface 428 may be obtained during the epitaxial growth of the S/D regions 418. As such, there may be no need to rely on an additional etching process, such as the one described above with respect to Figures 3A-3C. Particularly, embodiments may include S/D regions that are formed with an epitaxial process that has non-uniform growth rates. In an embodiment, the major surface 429 may grow at a faster rate than the recessed surface 428.

In an embodiment, the major surface 429 may grow at a faster rate than the recessed surface 428 because the crystal quality on which they are grown is different. Particularly, the crystal quality of the non-horizontal surface 406 (Figure 4B) of the substrate 405 is a higher quality than the horizontal surface 407 (Figure 4B) of the substrate 405. Surface 407 has a degraded crystal quality compared to the surface 406 because of the etching process used to recess surface 407. Accordingly, epitaxial growth of the S/D region 418 may organically form a recessed surface 428 that is surrounded by the major surface 429 in some embodiments described herein.

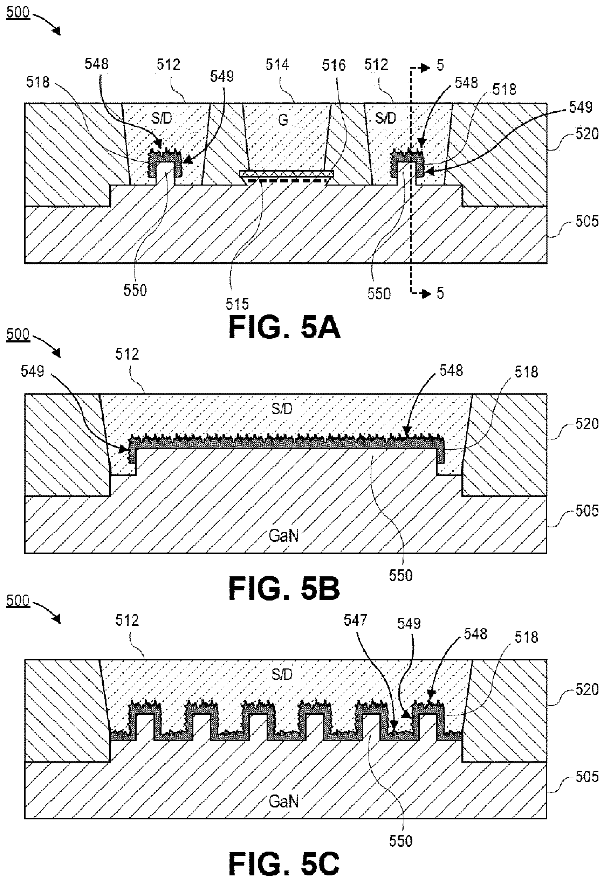

Referring now to Figure 5A, a cross-sectional illustration of a GaN transistor 500 with non-planar S/D regions 518 is shown, in accordance with an embodiment. In an embodiment, the GaN transistor 500 comprises non-planar S/D regions 518 that are formed over and around protrusions 550 from the substrate 505. In an embodiment, the S/D regions 518 may comprise portions 549 formed around sidewalls of the protrusions 550 and portions 548 formed over uppermost surfaces of the protrusions 550.

In the illustrated embodiment, the S/D regions 518 are illustrated as having a roughened surface. Embodiments may include forming a roughened surface with processes similar to those described above, with respect to Figure 2. For example, the S/D region 518 may comprise a semiconductor material that has a different lattice constant than the protrusion 550. Additional embodiments may include S/D regions 518 without a roughened surface. In such embodiments, the increased surface area may be entirely attributable to the non-planar shape of the S/D region 518 formed around and over the protrusions 550.

Referring now to Figure 5B, a cross-sectional illustration along a S/D region 518 of the GaN transistor 500 is shown, in accordance with an embodiment. In an embodiment, the protrusion 550 may be a single fin. Referring now to Figure 5C, a cross-sectional illustration along a S/D region 518 of the GaN transistor 500 is shown, in accordance with an additional embodiment. As shown in Figure 5C, the S/D region 518 may be formed over and around a plurality of protrusions 550. For example, the protrusions may comprise a plurality of pillars that extend up from the substrate 505. In some embodiments, the S/D region 518 may include portions 549 formed around the protrusions and portions 548 formed over the uppermost surface of the protrusions 550. Embodiments may also comprise portions 547 of the S/D region 518 formed over horizontal portions of the substrate 505. While the protrusions 550 in Figures 5A-5C are illustrated with substantially vertical sidewalls, it is to be appreciated that embodiments are not limited to such configurations. For examples, the protrusions 550 may have non-vertical sidewalls, such as sloping sidewalls, curved sidewalls, or any other shape.

Although the preceding methods of fabricating a metallization layer, or portions of a metallization layer, of a BEOL metallization layer are described in detail with respect to select operations, it is to be appreciated that additional or intermediate operations for fabrication may include standard microelectronic fabrication processes such as lithography, etch, thin films deposition, planarization (such as chemical mechanical polishing (CMP)), diffusion, metrology, the use of sacrificial layers, the use of etch stop layers, the use of planarization stop layers, or any other associated action with microelectronic component fabrication. Also, it is to be appreciated that the process operations described for the preceding process flows may be practiced in alternative sequences, not every operation need be performed or additional process operations may be performed or both.

In an embodiment, as used throughout the present description, interlayer dielectric (ILD) material is composed of or includes a layer of a dielectric or insulating material. Examples of suitable dielectric materials include, but are not limited to, oxides of silicon (e.g., silicon dioxide (SiO₂)), doped oxides of silicon, fluorinated oxides of silicon, carbon doped oxides of silicon, various low-k dielectric materials known in the arts, and combinations thereof. The interlayer dielectric material may be formed by techniques, such as, for example, chemical vapor deposition (CVD), physical vapor deposition (PVD), or by other deposition methods.

In an embodiment, as is also used throughout the present description, metal lines or interconnect line material (and via material) is composed of one or more metal or other conductive structures. A common example is the use of copper lines and structures that may or may not include barrier layers between the copper and surrounding ILD material. As used herein, the term metal includes alloys, stacks, and other combinations of multiple metals. For example, the metal interconnect lines may include barrier layers (e.g., layers including one or more of Ta, TaN, Ti or TiN), stacks of different metals or alloys, etc. Thus, the interconnect lines may be a single material layer, or may be formed from several layers, including conductive liner layers and fill layers. Any suitable deposition process, such as electroplating, chemical vapor deposition or physical vapor deposition, may be used to form interconnect lines. In an embodiment, the interconnect lines are composed of a conductive material such as, but not limited to, Cu, Al, Ti, Zr, Hf, V, Ru, Co, Ni, Pd, Pt, W, Ag, Au or alloys thereof. The interconnect lines are also sometimes referred to in the art as traces, wires, lines, metal, or simply interconnect.

In an embodiment, as is also used throughout the present description, sacrificial layers are composed of dielectric materials different from the interlayer dielectric material. In one embodiment, different sacrificial materials may be used in different regions so as to provide different growth or etch selectivity to each other and to the underlying dielectric and metal layers. In some embodiments, a sacrificial layer includes a layer of a nitride of silicon (e.g., silicon nitride) or a layer of an oxide of silicon, or both, or a combination thereof. Other suitable materials may include carbon-based materials. In another embodiment, a sacrificial material includes a metal species. For example, a sacrificial material or other overlying material may include a layer of a nitride of titanium or another metal (e.g., titanium nitride). Potentially lesser amounts of other materials, such as oxygen, may be included in one or more of these layers. Alternatively, other sacrificial layers known in the arts may be used depending upon the particular implementation. The sacrificial layers maybe formed by CVD, PVD, or by other deposition methods.

In an embodiment, as is also used throughout the present description, lithographic operations are performed using 193nm immersion lithography (i193), extreme ultra-violet (EUV) lithography or electron beam direct write (EBDW) lithography, or the like. A positive tone or a negative tone resist may be used. In one embodiment, a lithographic mask is a trilayer mask composed of a topographic masking portion, an anti-reflective coating (ARC) layer, and a photoresist layer. In a particular such embodiment, the topographic masking portion is a carbon hardmask (CHM) layer and the anti-reflective coating layer is a silicon ARC layer.

Patterned features (e.g., recessed surfaces described in Figure 3C and protrusions described in Figures 5C) may be patterned in a grating-like pattern with lines, holes or trenches spaced at a constant pitch and having a constant width. The pattern, for example, may be fabricated by a pitch halving or pitch quartering approach. In an example, a blanket film (such as a polycrystalline silicon film) is patterned using lithography and etch processing which may involve, e.g., spacer-based-quadruple-patterning (SBQP) or pitch quartering. It is to be appreciated that a grating pattern of lines can be fabricated by numerous methods, including 193nm immersion lithography (i193), extreme ultra-violet (EUV) and/or electron-beam direct write (EBDW) lithography, directed self-assembly, etc. In other embodiments, the pitch does not need to be constant, nor does the width.

Embodiments disclosed herein may be used to manufacture a wide variety of different types of integrated circuits and/or microelectronic devices. Examples of such integrated circuits include, but are not limited to, processors, chipset components, graphics processors, digital signal processors, micro-controllers, and the like. In other embodiments, semiconductor memory may be manufactured. Moreover, the integrated circuits or other microelectronic devices may be used in a wide variety of electronic devices known in the arts. For example, in computer systems (e.g., desktop, laptop, server), cellular phones, personal electronics, etc. The integrated circuits may be coupled with a bus and other components in the systems. For example, a processor may be coupled by one or more buses to a memory, a chipset, etc. Each of the processor, the memory, and the chipset, may potentially be manufactured using the approaches disclosed herein.

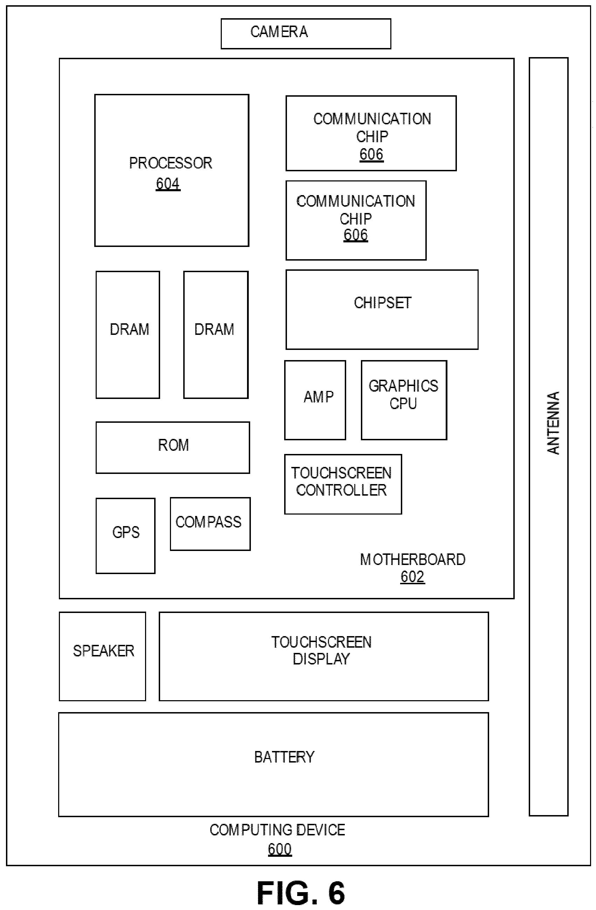

Figure 6 illustrates a computing device 600 in accordance with one implementation of an embodiment of the disclosure. The computing device 600 houses a board 602. The board 602 may include a number of components, including but not limited to a processor 604 and at least one communication chip 606. The processor 604 is physically and electrically coupled to the board 602. In some implementations the at least one communication chip 606 is also physically and electrically coupled to the board 602. In further implementations, the communication chip 606 is part of the processor 604.

Depending on its applications, computing device 600 may include other components that may or may not be physically and electrically coupled to the board 602. These other components include, but are not limited to, volatile memory (e.g., DRAM), non-volatile memory (e.g., ROM), flash memory, a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth).

The communication chip 606 enables wireless communications for the transfer of data to and from the computing device 600. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 606 may implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing device 600 may include a plurality of communication chips 606. For instance, a first communication chip 606 may be dedicated to shorter range wireless communications such as Wi-Fi and Bluetooth and a second communication chip 606 may be dedicated to longer range wireless communications such as GPS, EDGE, GPRS, CDMA, WiMAX, LTE, Ev-DO, and others.

The processor 604 of the computing device 600 includes an integrated circuit die packaged within the processor 604. In an embodiment, the integrated circuit die of the processor includes GaN transistors with non-planar S/D regions and/or surface roughened S/D regions, as described herein. The term "processor" may refer to any device or portion of a device that processes electronic data from registers and/or memory to transform that electronic data into other electronic data that may be stored in registers and/or memory.

The communication chip 606 also includes an integrated circuit die packaged within the communication chip 606. In an embodiment, the integrated circuit die of the communication chip includes GaN transistors with non-planar S/D regions and/or surface roughened S/D regions, as described herein.

In further implementations, another component housed within the computing device 600 may contain an integrated circuit die that includes GaN transistors with non-planar S/D regions and/or surface roughened S/D regions, as described herein.

In various implementations, the computing device 600 may be a laptop, a netbook, a notebook, an ultrabook, a smartphone, a tablet, a personal digital assistant (PDA), an ultra mobile PC, a mobile phone, a desktop computer, a server, a printer, a scanner, a monitor, a set-top box, an entertainment control unit, a digital camera, a portable music player, or a digital video recorder. In further implementations, the computing device 600 may be any other electronic device that processes data.

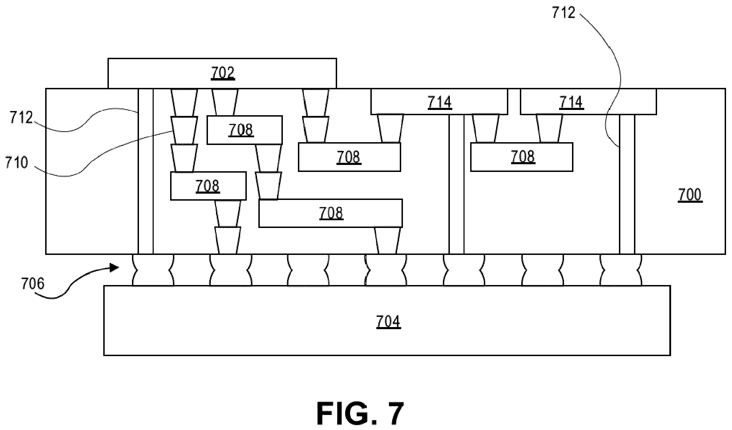

Figure 7 illustrates an interposer 700 that includes one or more embodiments of the disclosure. The interposer 700 is an intervening substrate used to bridge a first substrate 702 to a second substrate 704. The first substrate 702 may be, for instance, an integrated circuit die. The second substrate 704 may be, for instance, a memory module, a computer motherboard, or another integrated circuit die. Generally, the purpose of an interposer 700 is to spread a connection to a wider pitch or to reroute a connection to a different connection. For example, an interposer 700 may couple an integrated circuit die to a ball grid array (BGA) 706 that can subsequently be coupled to the second substrate 704. In some embodiments, the first and second substrates 702/704 are attached to opposing sides of the interposer 700. In other embodiments, the first and second substrates 702/704 are attached to the same side of the interposer 700. And in further embodiments, three or more substrates are interconnected by way of the interposer 700.

The interposer 700 may be formed of an epoxy resin, a fiberglass-reinforced epoxy resin, a ceramic material, or a polymer material such as polyimide. In further implementations, the interposer may be formed of alternate rigid or flexible materials that may include the same materials described above for use in a semiconductor substrate, such as silicon, germanium, and other group III-V and group IV materials.

The interposer may include metal interconnects 708 and vias 710, including but not limited to through-silicon vias (TSVs) 712. The interposer 700 may further include embedded devices 714, including both passive and active devices. Such devices include, but are not limited to, capacitors, decoupling capacitors, resistors, inductors, fuses, diodes, transformers, sensors, and electrostatic discharge (ESD) devices. More complex devices such as radiofrequency (RF) devices, power amplifiers, power management devices, antennas, arrays, sensors, and MEMS devices may also be formed on the interposer 700. In accordance with embodiments of the disclosure, apparatuses or processes disclosed herein may be used in the fabrication of interposer 700.

Thus, embodiments of the present disclosure include GaN transistors with non-planar S/D regions and/or surface roughened S/D regions, as described herein.

The above description of illustrated implementations of embodiments of the disclosure, including what is described in the Abstract, is not intended to be exhaustive or to limit the disclosure to the precise forms disclosed. While specific implementations of, and examples for, the disclosure are described herein for illustrative purposes, various equivalent modifications are possible within the scope of the disclosure, as those skilled in the relevant art will recognize.

These modifications may be made to the disclosure in light of the above detailed description. The terms used in the following claims should not be construed to limit the disclosure to the specific implementations disclosed in the specification and the claims. Rather, the scope of the disclosure is to be determined entirely by the following claims, which are to be construed in accordance with established doctrines of claim interpretation.

Example 1: a transistor device, comprising: a GaN channel; a source region and a drain region, wherein the source region is separated from the drain region by the GaN channel, and wherein the source region and the drain region comprise surfaces with a root mean squared (RMS) surface roughness greater than 3 nm; a gate electrode over the GaN channel; a source contact in contact with source region; and a drain contact in contact with the drain region.

Example 2: the transistor device of Example 1, wherein the source region and the drain region comprise a semiconductor material that has a different lattice constant than GaN.

Example 3: the transistor device of Example 1 or Example 2, wherein the source region and the drain region comprise InGaN.

Example 4: the transistor device of Examples 1-3, wherein the source and drain region comprise an atomic weight percent of In in InGaN that is between 15% and 20%.

Example 5: the transistor device of Examples 1-4, wherein an average thickness of the source and drain regions is 50 nm or greater.

Example 6: a transistor device, comprising: a GaN channel; a source region and a drain region, wherein the source region is separated from the drain region by the GaN channel, and wherein the source region and the drain region comprise a major surface and a recessed surface; a gate electrode over the GaN channel; a source contact in contact with the major surface and the recessed surface of the source region; and a drain contact in contact with the major surface and the recessed surface of the drain region.

Example 7: the transistor device of Example 6, wherein the recessed surfaces are surrounded by major surfaces of the source region and the drain region.

Example 8: the transistor device of Example 6 or Example 7, wherein the recessed surfaces have a slower epitaxial growth rate than the major surfaces.

Example 9: the transistor device of Examples 6-8, wherein surfaces of the source region and the drain region have a root mean squared (RMS) surface roughness that is greater than 3 nm.

Example 10: the transistor device of Examples 6-9, wherein the source region and the drain region comprise a semiconductor material that has a different lattice constant than GaN.

Example 11: the transistor device of Examples 6-10, wherein the source region and the drain region comprise InGaN.

Example 12: the transistor device of Examples 6-11, wherein the source and drain region comprise an atomic weight percent of In in InGaN that is between 15% and 20%.

Example 13: the transistor device of Examples 6-12, wherein the recessed surfaces are recessed with an etching process.

Example 14: the transistor device of Examples 6-13, wherein a root mean squared (RMS) surface roughness of the source and drain region is greater than 3 nm.

Example 15: the transistor device of Examples 6-14, wherein the recessed surfaces comprise trenches within the source and drain regions.

Example 16: the transistor device of Examples 6-15, wherein the recessed surfaces comprise a plurality of depressions within the source and drain regions.

Example 17: a transistor device, comprising: a GaN channel; a non-planar source region and a non-planar drain region, wherein the source region is separated from the drain region by the GaN channel, and wherein the source region and the drain region are disposed over and around non-planar semiconductor protrusions; a gate electrode over the GaN channel; a source contact in contact with the non-planar source region; and a drain contact in contact with the non-planar the drain region.

Example 18: the transistor device of Example 17, wherein the semiconductor protrusions are fins.

Example 19: the transistor device of Example 17 or Example 18, wherein the source region is formed over and around a plurality of semiconductor protrusions, and wherein the drain region is formed over and around a plurality of semiconductor protrusions.

Example 20: the transistor device of Examples 17-19, wherein the source region and the drain region have surfaces with a root mean squared (RMS) surface roughness that is greater than 3 nm.

Example 21: the transistor device of Examples 17-20, wherein the source region and the drain region comprise a lattice constant that is different than a lattice constant of the semiconductor protrusions.

Example 22: the transistor device of Examples 17-21, wherein the source region and the drain region comprise InGaN.

Example 23: the transistor device of Examples 17-23, wherein a thickness of the source region and the drain region over and around the semiconductor protrusions is 50 nm or more.

Example 24: a computing device, comprising: an integrated circuit die comprising a GaN transistor, and wherein the GaN transistor comprises: a GaN channel; a source region and a drain region, wherein the source region is separated from the drain region by the GaN channel, and wherein the source region and the drain region are non-planar; a gate electrode over the GaN channel; a source contact in contact with more than one surface of the source region; and a drain contact in contact with more than one surface of the drain region.

Example 25: the computing device of Example 24, wherein an atomic weight percent of In in InGaN is between 15% and 20%.

## Claims

1. A transistor device, comprising:
a GaN channel;
a source region and a drain region, wherein the source region is separated from the drain region by the GaN channel, and wherein the source region and the drain region comprise surfaces with a root mean squared (RMS) surface roughness greater than 3 nm;
a gate electrode over the GaN channel;
a source contact in contact with source region; and
a drain contact in contact with the drain region.

2. The transistor device of claim 1, wherein the source region and the drain region comprise a semiconductor material that has a different lattice constant than GaN.

3. The transistor device of claim 1 or 2, wherein the source region and the drain region comprise InGaN.

4. The transistor device of claim 1, 2 or 3, wherein the source and drain region comprise an atomic weight percent of In in InGaN that is between 15% and 20%.

5. The transistor device of claim 1, 2, 3 or 4, wherein an average thickness of the source and drain regions is 50 nm or greater.

6. A method of fabricating a transistor device, the method comprising:
forming a GaN channel;
forming a source region and a drain region, wherein the source region is separated from the drain region by the GaN channel, and wherein the source region and the drain region comprise surfaces with a root mean squared (RMS) surface roughness greater than 3 nm;
forming a gate electrode over the GaN channel;
forming a source contact in contact with source region; and
forming a drain contact in contact with the drain region.

7. The method of claim 6, wherein the source region and the drain region comprise a semiconductor material that has a different lattice constant than GaN.

8. The method of claim 6 or 7, wherein the source region and the drain region comprise InGaN.

9. The method of claim 6, 7 or 8, wherein the source and drain region comprise an atomic weight percent of In in InGaN that is between 15% and 20%.

10. The method of claim 6, 7, 8 or 9, wherein an average thickness of the source and drain regions is 50 nm or greater.
